# EUROPÄISCHE PATENTSCHRIFT

(11) **EP 2 989 869 B1**
(45) Veröffentlichungstag und Bekanntmachung des Hinweises auf die Patenterteilung: **17.06.2020**
(21) Anmeldenummer: 14781512.0
(22) Anmeldetag: 06.10.2014
(51) Int. Cl.: H05K 7/14, H05K 9/00, H05K 7/20

(54) **TRÄGERSTRUKTURANORDNUNG FÜR EINEN MODULATEN UMRICHTER**
SUPPORT STRUCTURE ARRANGEMENT FOR A MODULAR CONVERTER
ARRANGEMENT DE STRUCTURE DE SUPPORT POUR UN CONVERTISSEUR MODULAIRE

(30) Priorität: 04.10.2013 DE 102013111018
(43) Veröffentlichungstag der Anmeldung: 02.03.2016
(73) Patentinhaber: ABB Schweiz AG, 5400 Baden (CH)
(72) Erfinder: LINDBLOM, Marcus, CH-5116 Schinznach-Bad (CH); WEISS, Michael, CH-8404 Winterthur (CH)
(74) Vertreter: Kransell & Wennborg KB
(86) Internationale Anmeldenummer: PCT/EP2014/071294
(87) Internationale Veröffentlichungsnummer: WO 2015/049386

(56) Entgegenhaltungen:
- EP-A1- 0 389 910
- EP-A1- 1 178 593
- EP-A1- 1 329 145
- EP-A2- 0 992 424
- DE-A1- 19 856 776
- DE-A1-102009 007 956
- DE-C1- 3 931 570
- DE-U- 7 500 696
- US-A- 5 353 216
- US-A- 5 548 085

## Beschreibung

### GEBIET DER ERFINDUNG

Die Erfindung betrifft eine mechanische Trägerstrukturanordnung für einen modularen Umrichter, der eine Mehrzahl von Trägerstrukturen umfasst.

### HINTERGRUND DER ERFINDUNG

Wenn Leistungselektronikmodule oder PEBBs (Power Electronics Building Blocks) in Systemen, wie etwa Umrichtern, integriert werden, werden sie gewöhnlich an Trägern in einem Metallschrank als Trägerstruktur angeschraubt und manuell an Stromleitungen, Kühlsystem und Signalleitungen angeschlossen. In den meisten Umrichtern umfasst ein Leistungselektronikmodul einen Anschlusspunkt, an dem es mit Grundpotential verbunden ist, entweder direkt oder mittels einer elektrischen Leitung.

Wenn ein Leistungselektronikmodul derart eingesetzt werden soll, dass solch eine Verbindung zum Grundpotential nicht zweckmäßig ist (wie etwa häufig in einem Multiniveauumrichter) und mit einer Verbindung zu einem elektrischen Potential versehen werden soll, das sich vom Grundpotential unterscheidet, kann das Leistungselektronikmodul mit einem Gehäuse aus isolierendem Material oder mit feldhomogenisierenden Elementen ausgestattet werden, die innerhalb des Schranks mittels Isolatoren mit genügend großem Abstand zu dem Schrank und anderen umgebenden Komponenten angebracht werden. Der Schrank an sich befindet sich dabei normalerweise auf Grundpotential.

In den meisten wassergekühlten Leistungselektronikumrichtern befinden sich die Hauptsystemrohre für Kühlmittel auf einem Grundpotential und die Wärmesenken, die sich auf einem anderen elektrischen Potential befinden, sind mittels isolierender Rohre (beispielsweise Gummi oder Plastik) mit den Hauptsystemrohren verbunden. Wenn sich die Wärmesenken auf verschiedenem elektrischem Potential befinden, fließt in der Regel ein elektrischer Strom durch das Kühlwasser.

Manche Komponenten im Kühlmittelkreislauf beginnen zu korrodieren, wenn sie diesem Elektrolysestrom längere Zeit ausgesetzt sind. In bestimmten empirischen Studien wurden Sicherheitsstufen für verschiedene Metallmaterialien definiert, bei denen die Korrosionsrate niedrig genug ist, um sicherzustellen, dass keine Probleme während der Produktlebenszeit auftreten können. Typische Maßnahmen, um die Elektrolyseströme zu reduzieren und diese Sicherheitsstufen zu erreichen, umfassen deionisiertes Wasser und eine Anpassung der Geometrie der isolierenden Rohre.

Deionisiertes Wasser, das optional mit Glykol gemischt wird, um ein Frieren zu verhindern, weist eine sehr geringe Leitfähigkeit auf. Das Wasser kann auch bezüglich seiner Leitfähigkeit überwacht werden und die Leitfähigkeit durch kontinuierliches Entfernen von Ionen aus der Flüssigkeit niedrig gehalten werden.

Weiter kann die Länge der isolierenden Rohre erhöht und/oder ihr Durchmesser vermindert werden, um den Widerstand in diesen Abschnitten des Wasserkreislaufs zu erhöhen und damit die Elektrolyseströme auf die entsprechende Sicherheitsstufe zu senken.

In manchen Fällen ist es jedoch nicht sinnvoll oder möglich, die Geometrie der isolierenden Rohre entsprechend zu verändern. Bei bestimmten Spannungsniveaus müssten die Rohrlängen beispielsweise derart vergrößert werden, dass der Druck zu stark abfallen würde. Auch kann der zur Verfügung stehende Bauraum die Länge der Rohre begrenzen.

Die US5353216 offenbart eine elektrische Verteilungsvorrichtung und insbesondere ein Trägergestell für Schweiß- und Plasma-Lichtbogen-Wechselrichter-Stromquellen zur Verwendung auf Baustellen und an anderen Orten. Vorzugsweise werden eine primäre Eingangsspannung von 575 V und eine sekundäre Ausgangsspannung von 115 V verwendet.

### ZUSAMMENFASSUNG DER ERFINDUNG

Es ist Aufgabe der Erfindung, Leistungselektronikmodule auf einfache Weise von ihrer Umgebung elektrisch zu isolieren.

Diese Aufgabe wird durch den Gegenstand des unabhängigen Anspruchs 1 gelöst. Weitere Ausführungsformen der Erfindung ergeben sich aus den abhängigen Ansprüchen und aus der folgenden Beschreibung.

Ein Aspekt der Erfindung betrifft eine Trägerstrukturanordnung für einen modularen Umrichter, umfassend mehrere Trägerstrukturen für Leistungselektronik. Unter Leistungselektronik können dabei elektronische Komponenten (beispielsweise Halbleiter, Kondensatoren, Widerstände, Spulen, usw.) verstanden werden, die dafür ausgelegt sind, Spannungen über 1000 V und/oder Ströme über 10 A zu verarbeiten.

Gemäß einer Ausführungsform der Erfindung umfasst die Trägerstruktur eine Aufnahme zum Einschieben wenigstens eines Leistungselektronikmoduls und eine die Aufnahme umgebende, elektrisch leitfähige Außengeometrie, die abgerundete Ecken und Kanten mit einem Rundungsradius größer als einen vorgegebenen Minimalradius aufweist. Um die Einsatzspannung für Teilentladungen und Überschläge zu erhöhen, stehen keine scharfen Kanten und Ecken nach außen, insbesondere an Stellen, die weiteren Komponenten mit unterschiedlichem elektrischem Potential gegenüberliegen. Der kleinste Radius aller Ecken und Kanten kann entsprechend einer gewünschten Systemspannung des Elektronikmoduls gewählt werden.

Mit der Trägerstruktur können das oder die Leistungselektronikmodule mechanisch fixiert werden und kann eine Isolierung des oder der Leistungselektronikmodule hinsichtlich Teilentladungen und Überschlägen bereitgestellt werden. Weiter kann die Trägerstruktur eine Schnittstelle zu einer Kühlmittelleitung und/oder zu Signalkabeln bereitstellen.

Die Trägerstruktur ist zumindest teilweise aus elektrisch leitfähigem Material ausgeführt und weist eine Außengeometrie auf, die die elektrische Feldstärke an der Außenseite der Trägerstruktur homogenisiert. Die Trägerstruktur bzw. deren Außengeometrie stellt somit eine elektrische Abschirmung für die in ihrem Inneren enthaltenen Leistungselektronikmodule dar.

Die Trägerstruktur und in der Trägerstruktur aufgenommene Leistungselektronikmodule können zusammen eine mechanisch stabile Baugruppe bilden, aus der größere modulare Leistungselektronikgeräte, wie etwa Umrichter, aufgebaut werden können.

Die Trägerstruktur muss die in ihr enthaltenen bzw. aufgenommenen Leistungselektronikmodule und optional zusätzliche Elektronikkomponenten nicht vollständig umschließen. Sie kann Öffnungen aufweisen, durch die beispielsweise Moduleinsätze für Leistungselektronikmodule in die Trägerstruktur eingeschoben werden können. Die Trägerstruktur kann auch als Gehäuse, Regal oder Gestell für die enthaltenen Komponenten aufgefasst werden.

Gemäß einer Ausführungsform der Erfindung ist die Außengeometrie der Trägerstruktur quaderförmig. Beispielsweise kann die Trägerstruktur einen stapelbaren Kasten bzw. ein stapelbares Gehäuse aufweisen. Die Außengeometrie kann so ausgeführt sein, dass mehrere Trägerstrukturen nebeneinander und/oder übereinander gestapelt werden können.

Gemäß einer Ausführungsform der Erfindung umfasst die Trägerstruktur weiter einen Trägerrahmen aus miteinander verbundenen Rohren, insbesondere aus elektrisch leitendem Material wie etwa Metall, die die Ecken und Kanten der Trägerstruktur bilden. Die Rohre können beispielsweise Metallrohre sein. Die Rohre können einen kreisförmigen Querschnitt aufweisen mit insbesondere einem Radius größer als der oben genannte Minimalradius. Es sind jedoch auch andere Querschnittsformen möglich. Diese Rohre, beispielsweise Rohre mit Standardgrößen, können als Hauptstruktur verwendet werden. Die äußeren Dimensionen der Trägerstruktur können durch Verlängern und Verkürzen der Rohre leicht angepasst werden. Der minimale Radius der Ecken und Kanten kann durch Auswahl eines bestimmten Rohrdurchmessers festgelegt werden. Auf diese Weise kann auf einfache Weise eine Trägerstruktur mit abgerundeten Ecken und Kanten geschaffen werden, in der Leistungselektronikmodule abgeschirmt sind.

Gemäß einer Ausführungsform der Erfindung umfasst der Trägerrahmen zwei rechteckige Rohrringe mit abgerundeten Ecken, die parallel zueinander angeordnet sind und die mittels orthogonal zu den Rohrringen verlaufenden Rohren verbunden sind. Die Rohre können zu einem quaderförmigen Trägerrahmen verbunden werden.

Gemäß einer Ausführungsform der Erfindung umfasst die Trägerstruktur weiter wenigstens eine Seitenplatte, insbesondere aus elektrisch leitendem Material wie etwa Metall, die eine ebene Außenfläche der Außengeometrie bereitstellt. Die Seitenplatte kann ein Blech bzw. eine Blechplatte sein. Die Seitenplatte kann zwischen den Rohren des Trägerrahmens befestigt werden. Es ist zu verstehen, dass bei einer quaderförmigen Außengeometrie die Seitenplatte oder auch mehrere Seitenplatten an einer Oberseite, Unterseite, Vorderseite, Hinterseite, usw. befestigt werden kann.

Die Seitenplatte(n) stellen eine elektrische Abschirmung für die Seitenflächen der Trägerstruktur bereit. Mit den Seitenplatten kann die Steifheit der Trägerstruktur erhöht werden. Weiter können in der Seitenplatte Öffnungen für einen kontrollierten Luftstrom durch die Trägerstruktur vorgesehen sein.

Die Seitenplatte kann eine rechteckige Grundform mit abgerundeten Ecken aufweisen, wobei die abgerundeten Ecken einen Radius aufweisen, der größer als der Minimalradius ist.

Innerhalb der Rohre des Trägerahmens und der Seitenplatten, d.h. innerhalb der Außengeometrie, können geometrisch beliebig geformte Elemente (wie etwa Versteifungen und/oder Schienen) als weitere Trageelemente verwendet werden.

Gemäß einer Ausführungsform der Erfindung ist die wenigstens eine Seitenplatte zwischen Rohren eines Trägerrahmens der Trägerstruktur bereitgestellt. Die Seitenplatte kann in einer Seitenfläche des Trägerrahmens aufgenommen sein.

Gemäß einer Ausführungsform der Erfindung sind in die Aufnahme in der Trägerstruktur wenigstens zwei Leistungselektronikmodule hintereinander einschiebbar. Beispielsweise können zwei Leistungselektronikmodule zusammen eine Umrichterzelle für einen modularen Umrichter mit der Trägerstruktur bilden. Ein erstes Leistungselektronikmodul kann eine Kondensatorbank für einen Zellenkondensator umfassen. Ein zweites Leistungselektronikmodul kann eine Halbbrückenschaltung oder Vollbrückenschaltung umfassen, die mit der Kondensatorbank verbunden ist und diese bei entsprechender Ansteuerung laden und entladen kann.

Gemäß einer Ausführungsform der Erfindung umfasst die Trägerstruktur weiter wenigstens zwei Gleitschienen, die in der Aufnahme angeordnet sind, auf denen wenigstens ein Leistungselektronikmodul in die Aufnahme einschiebbar ist. Mit den Gleitschienen können ein oder mehrere Leistungselektronikmodule geführt und ausgerichtet werden, wenn das oder die Leistungselektronikmodule in die Trägerstruktur eingeschoben werden. Die Gleitschienen können das oder die Leistungselektronikmodule in der Trägerstruktur fixieren. Weiter können die Gleitschienen die mechanische Stärke und/oder Steifheit der Trägerstruktur erhöhen.

Gemäß einer Ausführungsform der Erfindung umfasst die Trägerstruktur weiter eine Mehrzahl von Isolatoren, die an der Außengeometrie angebracht sind. Über diese Isolatoren kann die Trägerstruktur an einer umgebenden Struktur oder an eine weitere Trägerstruktur befestigt werden. Die Isolatoren können beispielsweise an der Oberseite und/oder der Unterseite befestigt sein. Es ist jedoch auch möglich, die Isolatoren an den Seiten der Trägerstruktur zu befestigen.

Die Erfindung betrifft eine Trägerstrukturanordnung für einen modularen Umrichter. Ein modularer Umrichter kann dabei ein modularer Multiniveauumrichter mit einer Mehrzahl von in Reihe geschalteter Umrichterzellen sein, die jeweils eine Halbbrückenschaltung oder Vollbrückenschaltung mit einem daran angeschlossenen Zellenkondensator aufweisen können.

Gemäß einer Ausführungsform der Erfindung umfasst die Trägerstrukturanordnung eine Mehrzahl von Trägerstrukturen, so wie sie obenstehend und untenstehend beschrieben sind. Die Trägerstrukturen können dabei in einer (beispielsweise senkrechten oder waagrechten) Reihe angeordnet sein. Zwischen den Trägerstrukturen können Isolatoren angeordnet sein, über die die Trägerstrukturen miteinander verbunden sind. Auf diese Weise können die Trägerstrukturen alle ein eigenes elektrisches Potential aufweisen.

Gemäß einer Ausführungsform der Erfindung sind die Trägerstrukturen in mehreren aufeinander gestapelten Reihen angeordnet. Beispielsweise können jeweils zwei Trägerstrukturen aufeinander gestapelt werden. Auch hier ist es möglich, dass Isolatoren zwischen den beiden Trägerstrukturen angeordnet sind.

Gemäß einer Ausführungsform der Erfindung umfasst die Trägerstrukturanordnung weiter ein Kühlmittelrohr aus isolierendem Material zum Bereitstellen von Kühlflüssigkeit für Leistungselektronikmodule in den Trägerstrukturen. Das Kühlmittelrohr ist der Reihe entlang innerhalb der Außengeometrien der Trägerstrukturen geführt, beispielsweise durch eine Basis der Trägerstrukturen. Alle Kühlmittelrohre können aus isolierendem Material hergestellt sein, wie etwa Kunststoff, Gummi, Polypropylen, usw.

Viele oder alle Komponenten des Kühlkreislaufes können innerhalb der elektrischen Abschirmung angeordnet sein, die durch die Trägerstrukturen bereitgestellt wird, um die elektrischen Felder in der Umgebung der Komponenten zu beschränken und externe Einflüsse auf das Wasser und dielektrische Festkörper des Kühlkreislaufs zu reduzieren.

Das Kühlmittel kann beispielsweise Kühlwasser sein. Wassergekühlte Komponenten werden beispielsweise entweder direkt mit durch sie fließendem Wasser gekühlt (wie es etwa bei Widerständen und Kondensatoren der Fall sein kann) oder sie werden mit einer Wärmesenke in Verbindung gebracht (etwa bei Widerständen und Halbleitern).

In der Regel wird die Trägerstrukturanordnung ein Kühlmittelzulaufrohr und ein Kühlmittelablaufrohr aufweisen, die parallel verlaufen und die der Reihe entlang innerhalb der Außengeometrien der Trägerstrukturen geführt sind.

Gemäß einer Ausführungsform der Erfindung ist das oder die Kühlmittelrohre (Zulauf und/oder Ablauf) unterhalb von Schienen in den Trägerstrukturen geführt. Somit kann ein Leistungselektronikmodul über das Kühlmittelrohr hinweggeschoben werden.

Gemäß einer Ausführungsform der Erfindung umfasst die Trägerstrukturanordnung weiter wenigstens eine in dem Kühlmittelrohr angeordnete Elektrode innerhalb der Außengeometrie einer Trägerstruktur, die derart mit der Trägerstruktur und/oder einem Leistungselektronikbaustein in der Trägerstruktur elektrisch leitend verbunden ist, dass die Elektrode das Potential der Trägerstruktur und/oder des Leistungselektronikmoduls aufweist.

Anstatt zu versuchen, Elektrolyseströme durch das Kühlmittel zu begrenzen, können Elektroden aus einem im Wesentlichen korrosionsbeständigen Material (wie etwa Platin) verwendet werden, die in den Wasserkreislauf an bestimmten Punkten eingefügt werden und die auf das Potential eines Leistungselektronikmoduls gebracht werden. Der Elektrolysestrom fließt nur durch die Elektroden, die auf ein gewünschtes Potential gesetzt werden.

Im Betrieb des Umrichters kann die Elektrode damit das Potential des zugehörigen Leistungselektronikmoduls aufweisen. Im Falle dessen, dass ein Kühlmittelzulaufrohr und ein Kühlmittelablaufrohr vorhanden sind, kann jeweils eine Elektrode im Zulaufrohr und im Ablaufrohr innerhalb der Außengeometrie der Trägerstruktur angeordnet sein.

Gemäß einer Ausführungsform der Erfindung ist die Elektrode in einer ersten Trägerstruktur in der Reihe aus Trägerstrukturen und eine weitere Elektrode in der letzten Trägerstruktur aus dieser Reihe angeordnet. Somit kann zumindest die Komponente des Elektrolysestroms, die durch unterschiedliches Potential der Leistungselektronikmodule, die an das Kühlmittelrohr angeschlossen sind, verursacht wird, auf die Reihe von Trägerstrukturen begrenzt werden.

Insbesondere bei einem modularen Multiniveauumrichter kann dessen Nennspannung mit der Systemleistung variieren. Wenn gekühlte Komponenten und Wärmesenken auf ein Potential relativ zum Grundpotential gesetzt werden, können die Potentiale der Leistungselektronikmodule um den Faktor 10 größer sein als bei Standardsystemen.

Gemäß einer Ausführungsform der Erfindung umfasst die Trägerstrukturanordnung weiter ein Verbindungsrohr aus einem isolierenden Material zum Verbinden des Kühlmittelrohrs zu einem Hauptsystemrohr und eine Elektrode, die im Verbindungsrohr angeordnet ist, und die elektrisch mit einem Grundpotential des Umrichters verbunden ist.

Im Falle eines Zulaufrohrs und eines Ablaufrohrs können die beiden Rohre jeweils über ein Zulaufverbindungsrohr und ein Ablaufverbindungsrohr mit dem jeweiligen Rohr des Hauptsystems verbunden werden. In der Regel sind die Hauptsystemrohre aus Metall, also elektrisch leitend ausgeführt. Mit der Elektrode auf Grundpotential im Verbindungsrohr kann ein Elektrolysestrom zwischen den Hauptsystemrohren und den Leistungselektronikmodulen nahezu vollständig unterdrückt werden.

Gemäß einer Ausführungsform der Erfindung umfasst die Trägerstrukturanordnung weiter eine erste Gruppe von Trägerstrukturen in der Reihe und eine zweite Gruppe von Trägerstrukturen in der Reihe anschließend an die erste Gruppe und ein weiteres Kühlmittelrohr für die zweite Gruppe von Trägerstrukturen, das durch die Trägerstrukturen der ersten Gruppe geführt ist. Der Aufbau der isolierenden Kühlmittelrohre mit den eingefügten Elektroden ist bezüglich der Systemspannung skalierbar, ohne dass das Gehäuse des Umrichters oder andere Komponenten zusätzlich in Betracht gezogen werden müssen. Beispielsweise kann eine Elektrode auf Grundpotential in der Verbindung der ersten Gruppe zum Hauptsystemrohr, eine Elektrode in der ersten Trägerstruktur der ersten Gruppe und eine Elektrode in der letzten Trägerstruktur der ersten Gruppe im entsprechenden Abschnitt des Kühlmittelkreislaufs, d.h. in den Kühlmittelrohren, angeordnet werden. Weiter kann eine Elektrode auf Grundpotential in der Verbindung der zweiten Gruppe zum Hauptsystemrohr, eine Elektrode in der ersten Trägerstruktur der zweiten Gruppe und eine Elektrode in der letzten Trägerstruktur der zweiten Gruppe in den Kühlmittelrohren angeordnet werden.

### KURZE BESCHREIBUNG DER FIGUREN

Im Folgenden werden Ausführungsbeispiele der Erfindung mit Bezug auf die beiliegenden Figuren detailliert beschrieben.
Fig. 1 zeigt eine perspektivische Ansicht einer Trägerstruktur gemäß einer Ausführungsform der Erfindung.
Fig. 2 zeigt eine perspektivische Ansicht der Trägerstruktur aus Fig. 1 zusammen mit zwei Leistungselektronikmodulen.
Fig. 3 zeigt eine perspektivische Ansicht der Trägerstruktur aus Fig. 1 zusammen mit zwei eingeschobenen Leistungselektronikmodulen.
Fig. 4 zeigt einen Querschnitt durch ein Detail der Trägerstruktur aus Fig. 1.
Fig. 5 zeigt einen Querschnitt durch ein weiteres Detail der Trägerstruktur aus Fig. 1.
Fig. 6 zeigt eine perspektivische Ansicht einer Trägerstrukturanordnung gemäß einer Ausführungsform der Erfindung.
Fig. 7 zeigt eine perspektivische Ansicht eines Kühlmittelkreislaufs für die Trägerstrukturanordnung aus der Fig. 6.
Fig. 8 zeigt einen Querschnitt durch ein Detail der Trägerstrukturanordnung aus Fig. 6.
Fig. 9 zeigt einen Querschnitt durch ein Kühlmittelrohr der Trägerstrukturanordnung aus Fig. 6.
Fig. 10 zeigt eine perspektivische Ansicht eines weiteren Kühlmittelkreislaufs für eine Trägerstrukturanordnung gemäß einer weiteren Ausführungsform der Erfindung. Die in den Figuren verwendeten Bezugszeichen und ihre Bedeutung sind in zusammenfassender Form in der Liste der Bezugszeichen aufgeführt. Grundsätzlich sind identische oder ähnliche Teile mit den gleichen Bezugszeichen versehen.

### DETAILLIERTE BESCHREIBUNG VON AUSFÜHRUNGSBEISPIELEN

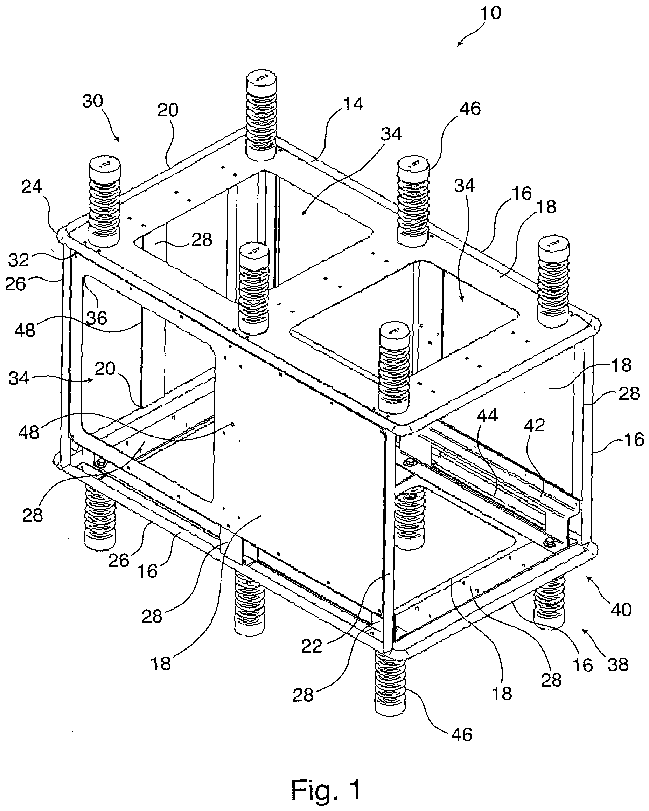

Fig. 1 zeigt eine perspektivische Ansicht einer Trägerstruktur 10, die aus einem Trägerrahmen 14 aus Metallrohren 16 mit dazwischen aufgehängten Seiten- bzw. Blechplatten 18 zusammengebaut ist.

Der Trägerrahmen 14 hat eine im Wesentlichen quaderförmige Außenform und umfasst zwei rechteckige Rohrringe 20, die mittels vier weiterer Rohre 22, die im Wesentlichen orthogonal zu den Ebenen der Rohrringe 20 verlaufen, miteinander verbunden sind. Die Verbindungsstellen der Rohre 22 mit den Rohrringen 20 sind versetzt zu den abgerundeten Ecken 24 der Rohrringe 20 angeordnet.

Die Rohre 16, 20, 22 können zusammengesteckt und/oder miteinander verschweißt sein, so dass der Rohrrahmen bzw. Trägerrahmen 14 entsteht. Alle abgerundeten Ecken 24 und Kanten 26 für die Trägerstruktur 10 werden durch Außenflächen der Rohre 16, 20, 22 bereitgestellt.

Der Trägerrahmen 14 kann an einer oder mehreren Seiten (inklusive oben und unten) mit Seitenplatten 18 versehen werden. An den Rohren 16, 20, 22 sind die Seitenplatten 18 über weitere Versteifungselemente 28 befestigt, die gegenüber den Rohren 16, 20, 22 (leicht) nach innen versetzt sind. Auf diese Weise entsteht eine Außengeometrie 30, die nach außen lediglich abgerundete Ecken 24 und Kanten 26 aufweist.

Die Versteifungselemente 28, die mit den Rohren 16, 20, 22 verschweißt sein können, sind rechteckige Metallstreifen, die innerhalb der Seitenplatten 18 angeordnet sind und/oder gegenüber den Rohren 16, 20, 22 nach innen versetzt sind.

Die Seitenplatten 18 sind rechteckig mit abgerundeten Ecken 32 und können eine oder mehrere Öffnungen 34, beispielsweise für Kühlluft, aufweisen. Auch die Öffnungen 34 weisen abgerundete Ecken 36 auf.

In der Trägerstruktur 10 befindet sich eine Aufnahme 38 mit im Wesentlichen quaderförmigem Innenvolumen, die von der im Wesentlichen quaderförmigen Außengeometrie umgeben ist. Über eine Öffnung 40 kann eines oder mehrere Leistungselektronikmodule in die Trägerstruktur 10 eingeschoben werden. Die Trägerstruktur 10 kann auf ein hohes elektrisches Potential bezüglich eines Grundpotentials oder bezüglich anderer Trägerstrukturen 10 gesetzt werden. Eine hohe Spannungsisolierung wird durch eine Abschirmung erreicht, die die elektrische Feldstärke um die Leistungselektronikmodule homogenisiert. Diese Abschirmung wird durch die abgerundeten Kanten 26 und Ecken 24, 32, 36 der Trägerstruktur 10 bereitgestellt. Diese Außengeometrie 30 der Trägerstruktur 10 erhöht die Einsetzspannung für Teilentladungen und Überschläge.

Insbesondere sind die Kanten 26 und Ecken 24, 32, 36 so ausgeführt, dass ihre Krümmungsradien alle größer als ein Minimalradius sind, der für die Trägerstruktur 10 festgelegt wurde.

Innerhalb der Trägerstruktur 10 können Gleitschienen 42 befestigt sein. Die im Wesentlichen W- förmigen Gleitschienen 42 sind an einer Basis der Trägerstruktur 10 befestigt, beispielsweise über die Versteifungselemente 28.

In den Gleitschienen 42 befinden sich unterhalb der Gleitfläche seitliche Öffnungen 44, durch die beispielsweise Kühlmittelrohre (siehe weiter unten) durch die Trägerstruktur geschoben werden können. Die Seitenplatten 18 links und rechts neben der Aufnahme 38 verlaufen aus diesem Grund auch nicht bis zu den unteren Rohren 16, sondern lassen einen unteren Abschnitt an der Basis frei.

An der Trägerstruktur 10 können Isolatoren 46, beispielsweise Standardisolatoren, befestigt sein. Beispielsweise können jeweils sechs Isolatoren 46 an der oberen Seitenplatte 18 und der unteren Seitenplatte 18 befestigt sein. Die Befestigung kann zusätzlich über die Versteifungselemente 28 erfolgen.

An der Trägerstruktur 10 können Befestigungspunkte 48 (wie etwa Löcher für Nieten oder Schrauben) für Isolatoren 46 in den Seitenplatten 18 vorgesehen sein, nicht nur in der oberen und unteren Seitenplatte 18, sondern auch in der hinteren, linken und rechten Seitenplatte 18.

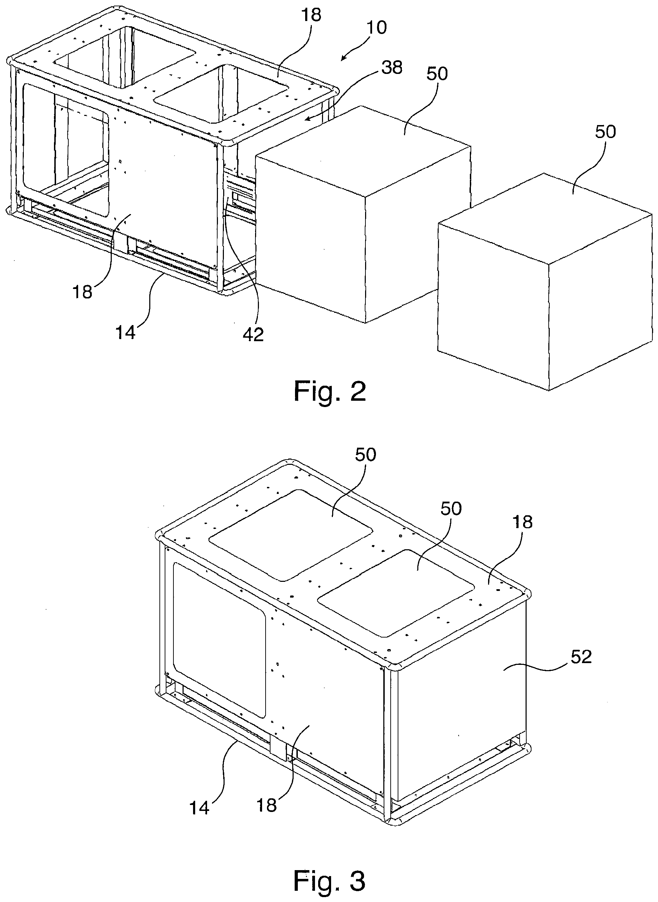

Die Fig. 2 zeigt die Trägerstruktur 10 aus der Fig. 1 zusammen mit zwei Leistungselektronikmodulen 50 (ohne die Isolatoren 46). Die Leistungselektronikmodule 50 sind lediglich schematisch als Quader dargestellt, können aber eine wesentlich kompliziertere Außenform aufweisen.

In der Trägerstruktur 10 können die Leistungselektronikmodule 50 dadurch installiert werden, dass sie in die Aufnahme 38 auf den Schienen 42 nacheinander eingeschoben werden. Die Fig. 3 zeigt die Trägerstruktur 10 mit den beiden eingeschobenen Leistungselektronikmodulen 50. Die Öffnung 40 der Aufnahme kann anschließend mit einer Deckplatte 52 verschlossen werden, die genauso wie die Seitenplatten 18 eine Blechplatte sein kann.

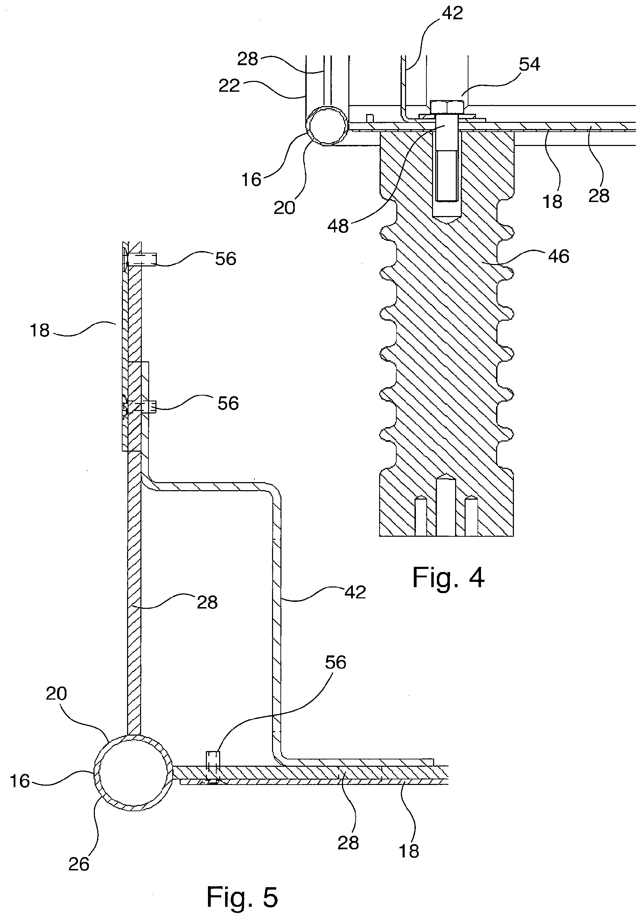

Die Fig. 4 zeigt einen Querschnitt durch die Trägerstruktur 10 im Bereich eines Isolators 46. Der Isolator 46 ist von der Innenseite der Trägerstruktur 10 aus, beispielsweise mittels einer Schraube 54, befestigt. Dabei verläuft die Öffnung 48, durch die die Schraube 54 verläuft, durch einen Fuß der Schiene 42, ein Versteifungselement 28 und eine Seitenplatte 18.

Fig. 5 zeigt einen Querschnitt durch die Trägerstruktur 10 im Bereich einer Schiene 42. Um hohe Feldstärken an Stellen zu vermeiden, an denen Befestigungsmittel 56 nach außen weisen, können versenkte Befestigungsmittel 56, wie etwa Senkschrauben oder Senknieten, verwendet werden. Beispielsweise kann eine Seitenplatte 18 mit einem versenkten Befestigungsmittel 56 an ein Versteifungselement 28 und/oder die Schiene 42 mit einem versenkten Befestigungsmittel 56 an ein Versteifungselement 28 befestigt werden.

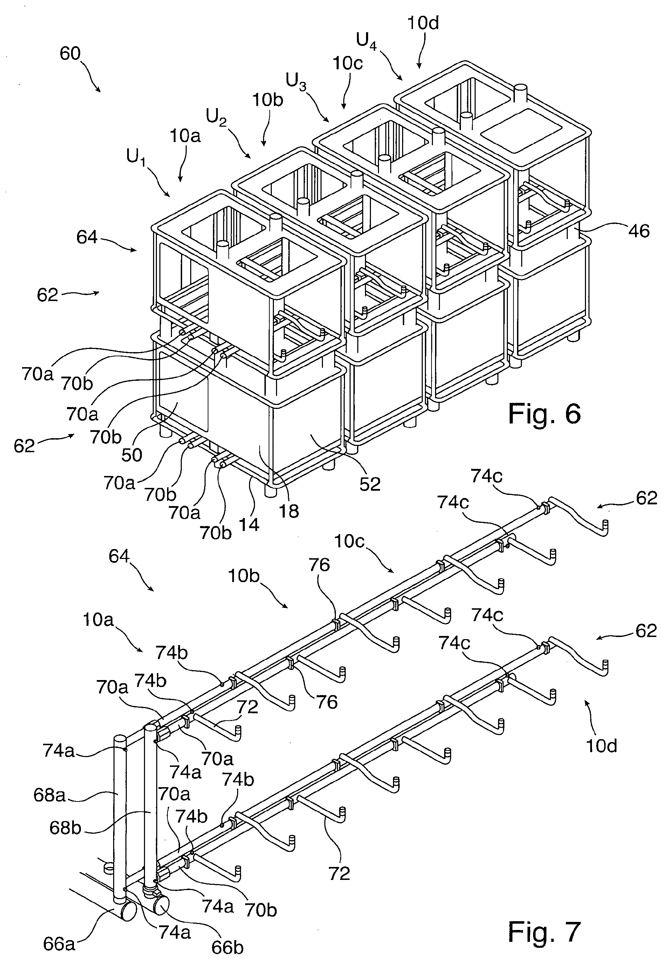

Fig. 6 zeigt eine Trägerstrukturanordnung 60, die aus zwei übereinander angeordneten Reihen 62 von Trägerstrukturen 10a, 10b, 10c, 10d aufgebaut ist, die durch Isolatoren 46 aufeinander abgestützt sind. Nur in der unteren Reihe 62 sind Leistungselektronikmodule 50 dargestellt, so dass in der oberen Reihe Rohre des Kühlkreislaufs 64 sichtbar sind. Andere Anordnungen sind jedoch auch möglich, wie etwa senkrechte Reihen.

Zusammen mit den Leistungselektronikmodulen 50 kann die Trägerstrukturanordnung 60 die Leistungselektronik eines modularen Multiniveauumrichters umfassen, wobei die Leistungselektronikmodule 50 elektrisch in Reihe geschaltet sind (beispielsweise entlang der Reihe 62). Die Trägerstruktur 10a, 10b, 10c, 10d bzw. das Gehäuse jedes Leistungselektronikmoduls 50 befindet sich dann auf einem elektrischen Potential Ui, U2, Un relativ zum Grundpotential. Die elektrischen Potentiale verschiedener Trägerstrukturen 10a, 10b, 10c, lOd bzw. Leistungselektronikmodule 50 können sich unterscheiden. Beispielsweise kann die Spannungsdifferenz zwischen benachbarten Leistungselektronikmodulen 50 die gleiche Größenordnung aufweisen.

Die Fig. 7 zeigt den Kühlmittelkreislauf 64 für die Trägerstrukturanordnung 60 aus der Fig. 6. Die gesamte Anordnung 60 wird über Hauptsystemrohre 66a, 66b (einem Hauptsystemzulaufrohr 66a und einem Hauptsystemablaufrohr 66b) mit Kühlmittel, wie etwa Kühlwasser, versorgt. Die beiden Hauptsystemrohre 66a, 66b sind in der Regel Metallrohre und befinden sich auf Grundpotential.

Die Hauptsystemrohre 66a, 66b sind über Verbindungsrohre 68a, 68b (ein Zulaufverbindungsrohr 68a und ein Ablaufverbindungsrohr 68b) mit Kühlmittelrohren 70a, 70b (ein Kühlmittelzulaufrohr 70a und ein Kühlmittelablaufrohr 70b) verbunden. Sowohl die untere Reihe 62 als auch die obere Reihe 62 weisen jeweils zwei oder vier (siehe Fig. 6) Kühlmittelrohre 70a, 70b auf. Die Verbindungsrohre 68a, 68b und die Kühlmittelrohre 70a, 70b sind aus einem isolierenden Material, wie etwa Kunststoff oder Gummi, gefertigt.

Die Wärmesenken der einzelnen Leistungselektronikmodule 50 sind über Schläuche 72 mit den Kühlmittelrohren 70a, 70b verbunden.

Wie aus der Fig. 6 hervorgeht, sind die Kühlmittelrohre 70a, 70b durch seitliche Öffnungen durch die Basis der Trägerstrukturen 10 geführt. Dabei werden sie unterhalb der Seitenplatten 18 und oberhalb des Rohrs 16 des Trägerrahmens 14 durch die Öffnung 44 der Schienen 42 geführt. Damit sind die Kunststoffrohre 70a, 70b, 72 zum Wasserzulauf und Wasserablauf durch die Abschirmungen der Trägerstrukturen 10a, 10b, 10c, 10d hindurch entlang der Umrichterlänge angeordnet.

Da die Kühlmitterohre 70a, 70b und Schläuche 72 innerhalb der elektrischen Abschirmung verlaufen, die durch die Trägerstruktur 10 der Leistungselektronikmodule 50 bereitgestellt wird, muss keine Isolierung hinsichtlich eines Außenbereichs berücksichtigt werden. Alle mechanischen Befestigungen, Rohrklammern, usw. sind innerhalb der Abschirmung angebracht.

Um zu steuern, wo die Elektrolyseströme in den Wasserkreislauf 64 eintreten und den Wasserkreislauf 64 verlassen, sind Elektroden 74a, 74b, 74c im Wasserkreislauf angeordnet: Eine Elektrode 74a auf Grundpotential in den Verbindungsrohren 68a, 68b, eine Elektrode 74b auf dem Potential Ui des ersten Leistungselektronikmoduls 50 in der ersten Trägerstruktur 10a und eine Elektrode 74c auf dem Potential U₄ (im allgemeinen Un) des letzten Leistungselektronikmoduls 50 in der letzten Trägerstruktur 10d.

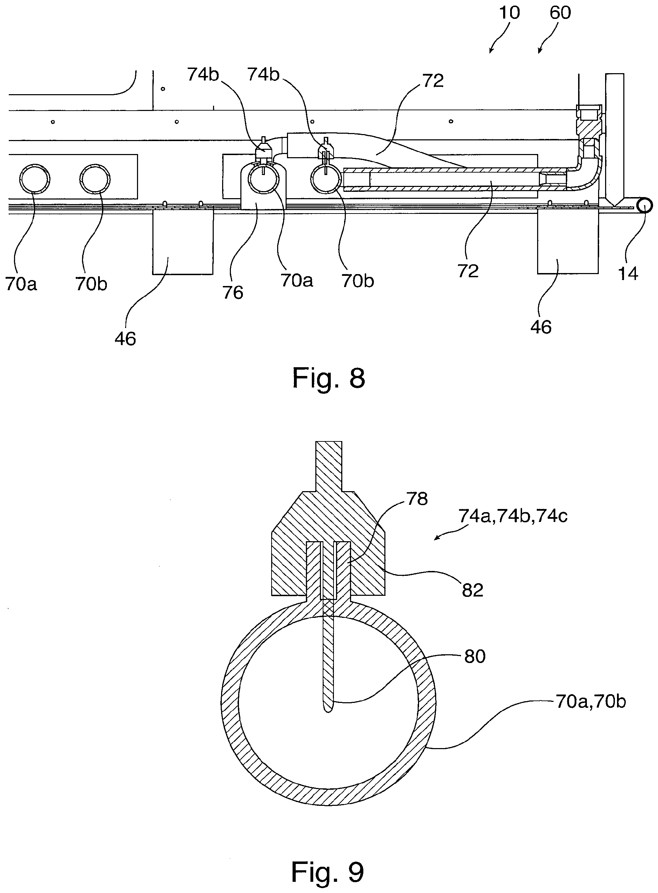

Die Fig. 8 zeigt einen Querschnitt durch die Trägerstrukturanordnung 60. In der Mitte jeder Trägerstruktur sind die Zulauf- bzw. Ablaufrohre 70a, 70b mit einer Klammer 76 befestigt, in der sich das betreffende Rohr 70a, 70b in axialer Richtung bewegen kann. Auf diese Weise kann eine thermische Längenänderung der Kunststoffrohre 70a, 70b kompensiert werden. Die Fig. 9 zeigt einen Querschnitt durch ein Kühlmittelrohr 70a, 70b der Trägerstrukturanordnung 60 im Bereich einer Elektrode 74, 74b, 74c. Das Kühlmittelrohr 70a, 70b weist ein kleines aufgesetztes Rohr als Aufnahme 78 für die Elektrodenspitze 80 auf, die in die Mitte des Kühlmittelrohrs 70a, 70b gesetzt werden kann. Über den Rand der Aufnahme 78 kann ein Deckel 82 der Elektrode gesteckt bzw. aufgeschraubt werden, der die Elektrode am Kühlmittelrohr 70a, 70b befestigt und dieses dicht verschließt.

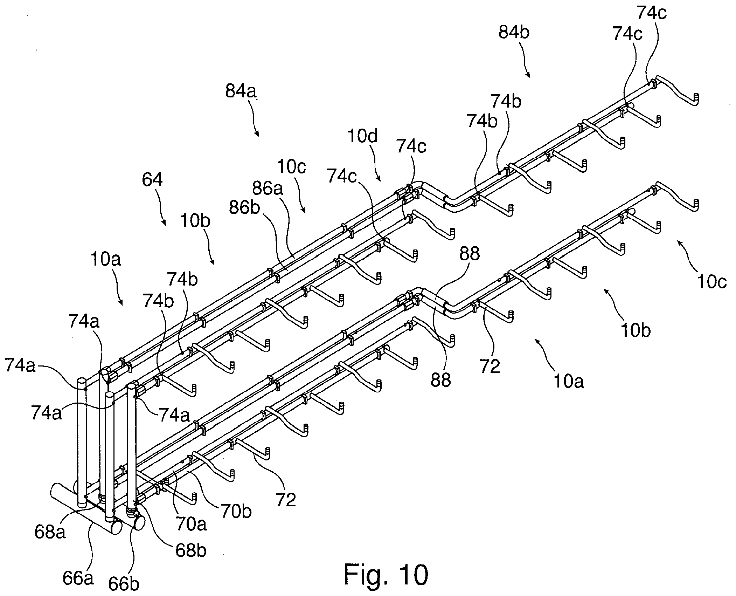

Die Fig. 10 zeigt eine perspektivische Ansicht eines weiteren Kühlmittelkreislaufs 64. Eine Reihe 64 von Trägerstrukturen 10 bzw. Leistungselektronikmodulen 50 wird dabei in zwei Gruppen 84a, 84b eingeteilt, die aufeinander anschließen, aber durch zwei getrennte Rohrsysteme entsprechend der Fig. 7 mit Kühlmittel versorgt werden.

Die zweite Gruppe 84b kann dabei von zusätzlichen Rohren 86a, 86b (einem zusätzlichen Zulaufrohr 86a und einem zusätzlichen Ablaufrohr 86b) versorgt werden, die in die entsprechenden Kühlmittelrohre der zweiten Gruppe 84b münden. Die zusätzlichen Rohre verlaufen dabei durch die Basis der Trägerstrukturen 10a bis 10d der ersten Gruppe 84a. Ein flexibler Abschnitt (beispielsweise ein Gummischlauch) 88 kann die thermische Ausdehnung der Rohre 70a, 70b, 86a, 86b kompensieren.

Auch die zweite Gruppe 84b kann wie die erste Gruppe 84a mit Elektroden ausgestattet werden: Eine Elektrode 74a auf Grundpotential in den Verbindungsrohren 68a, 68b, eine Elektrode 74b auf dem Potential U5 des ersten Leistungselektronikmoduls 50 in der ersten Trägerstruktur 10a der zweiten Gruppe 84b und eine Elektrode 74c auf dem Potential U7 (im allgemeinen Un) des letzten Leistungselektronikmoduls 50 in der letzten Trägerstruktur 10d der zweiten Gruppe 84b.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### LISTE DER BEZUGSZEICHEN

10 Trägerstruktur
14 Trägerrahmen
16 Rohre
18 Seitenplatte
20 Rohrring
22 Verbindungsrohr
24 abgerundete Ecke
26 abgerundete Kante
28 Versteifungselement
30 Außengeometrie
32 abgerundete Ecke
34 Öffnung in Seitenplatte
36 abgerundete Ecke
38 Aufnahme
40 Öffnung in Aufnahme
42 Gleitschiene
44 seitliche Öffnung in Gleitschiene
46 Isolator
48 Befestigungspunkt für Isolator
50 Leistungselektronikmodul
52 Deckplatte
54 Schraube
56 versenkte Befestigungsmittel
60 Trägerstrukturanordnung
62 Reihe von Trägerstrukturen
64 Kühlmittelkreislauf
66a, 66b Hauptsystemrohr
68a, 68b Verbindungsrohr
70a, 70b Kühlmittelrohr
72 Schlauch
74a, 74b, 74c Elektrode
76 Klemme
78 Aufnahme
80 Elektrodenspitze
82 Elektrodendeckel
84a, 84b Gruppe von Trägerstrukturen
86a, 86b zusätzliche Kühlmittelrohre
88 elastischer Abschnitt

## Patentansprüche

1. Trägerstrukturanordnung (60) für einen modularen Umrichter, die Trägerstrukturanordnung (60) umfassend:
eine Mehrzahl von in einer Reihe (62) angeordneten Trägerstrukturen (10), wobei jede Trägerstruktur umfasst:
eine Aufnahme (38) zum Einschieben wenigstens eines Leistungselektronikmoduls (50); und
einen Trägerrahmen (14) aus miteinander verbundenen Rohren (16, 22), welche Ecken (24) und Kanten (26) einer die Aufnahme (38) umgebenden, elektrisch leitfähigen Außengeometrie (30) bilden,
wobei die Ecken (24) und Kanten (26) einen Rundungsradius größer als einen vorgegebenen Minimalradius aufweisen und wobei die Außengeometrie (30) dazu ausgeführt ist, eine elektrische Feldstärke an einer Außenseite der Trägerstruktur (10) zu homogenisieren, und
wobei der Trägerrahmen (14) zwei rechteckige Rohrringe (20) mit abgerundeten Ecken umfasst, die parallel zueinander angeordnet sind und die mittels orthogonal zu den Rohrringen verlaufenden Rohren (22) verbunden sind,
wobei jede der Trägerstrukturen (10) weiter umfasst :
eine Mehrzahl von Isolatoren (46), die an der Außengeometrie (30) angebracht und dazu ausgeführt sind, dass die Trägerstruktur an einer umgebenden Struktur oder an einer weiteren Trägerstruktur befestigt werden kann,
wobei die Trägerstrukturanordnung (60) weiter umfasst:
ein Kühlmittelrohr (70a, 70b) aus isolierendem Material zum Bereitstellen von Kühlflüssigkeit für Leistungselektronikmodule (50) in den Trägerstrukturen (10a, 10b, 10c, 10d); und
wenigstens eine in dem Kühlmittelrohr (70a, 70b) angeordnete Elektrode (74b, 74c) innerhalb der Außengeometrie (30) einer Trägerstruktur (10a, 10b, 10c, 10d), die derart mit der Trägerstruktur verbunden ist und/oder einem Leistungselektronikmodul in der Trägerstruktur elektrisch leitend verbindbar ist, dass die Elektrode das Potential der Trägerstruktur und/oder des Leistungselektronikmoduls aufweist,
wobei das Kühlmittelrohr (70a, 70b) der Reihe (62) entlang innerhalb der Außengeometrien (30) der Trägerstrukturen (10a, 10b, 10c, 10d) geführt ist, und
wobei die Elektrode (74b) in einer ersten Trägerstruktur (10a) in der Reihe (62) und eine weitere Elektrode (74c) in der letzten Trägerstruktur (10d) aus der Reihe angeordnet ist.

2. Trägerstrukturanordnung (60) nach Anspruch 1,
wobei die Außengeometrie (30) der Mehrzahl von Trägerstrukturen (10) quaderförmig ist.

3. Trägerstrukturanordnung (60) nach Anspruch 1 oder 2, wobei die Mehrzahl von Trägerstrukturen (10) jeweils weiter umfasst:
wenigstens eine Seitenplatte (18), die eine ebene Außenfläche der Außengeometrie (30) bereitstellt.

4. Trägerstrukturanordnung (60) nach Anspruch 3,
wobei die wenigstens eine Seitenplatte (18) zwischen Rohren (16, 20, 22) eines Trägerrahmens (14) der Mehrzahl von Trägerstrukturen bereitgestellt ist.

5. Trägerstrukturanordnung (60) nach einem der vorhergehenden Ansprüche,
wobei in die Aufnahme (38) wenigstens zwei Leistungselektronikmodule (50) hintereinander einschiebbar sind.

6. Trägerstrukturanordnung (60) nach einem der vorhergehenden Ansprüche, weiter umfassend:
wenigstens zwei Gleitschienen (42), die in der Aufnahme (38) angeordnet sind, auf denen wenigstens ein Leistungselektronikmodul (50) in die Aufnahme einschiebbar ist.

7. Trägerstrukturanordnung (60) nach einem der vorhergehenden Ansprüche,
wobei das Kühlmittelrohr (70a, 70b) unterhalb von Schienen (42) in den Trägerstrukturen (10a, 10b, 10c, 10d) geführt ist.

8. Trägerstrukturanordnung (60) nach einem der vorhergehenden Ansprüche, weiter umfassend:
ein Verbindungsrohr (68a, 68b) aus einem isolierenden Material zum Verbinden des Kühlmittelrohrs (70a, 70b) zu einem Hauptsystemrohr (66a, 66b);
eine Elektrode (74a), die im Verbindungsrohr angeordnet ist, und die elektrisch mit einem Grundpotential des modularen Umrichters verbindbar ist.

9. Trägerstrukturanordnung nach einem der vorhergehenden Ansprüche, weiter umfassend:
eine erste Gruppe (64a) von Trägerstrukturen in der Reihe und eine zweite Gruppe (64b) von Trägerstrukturen in der Reihe anschließend an die erste Gruppe (64a);
ein weiteres Kühlmittelrohr (86a, 86b) für die zweite Gruppe (64b) von Trägerstrukturen, das durch die Trägerstrukturen der ersten Gruppe (64a) geführt ist.

## Claims

1. Support structure arrangement (60) for a modular converter, the support structure arrangement (60) comprising:
a plurality of support structures (10) which are arranged in a row (62), wherein each support structure comprises:
a holder (38) for the insertion of at least one power electronics module (50); and
a support frame (14) which is composed of pipes (16, 22) which are connected to one another and form corners (24) and edges (26) of an electrically conductive outer geometry (30) which surrounds the holder (38),
wherein the corners (24) and edges (26) have a radius of curvature which is greater than a prespecified minimum radius, and wherein the outer geometry (30) is designed to homogenize an electrical field strength on an outside of the support structure (10), and
wherein the support frame (14) comprises two rectangular pipe rings (20) with rounded corners, which pipe rings are arranged parallel in relation to one another and are connected by means of pipes (22) which run orthogonally in relation to the pipe rings,
wherein each of the support structures (10) further comprises:
a plurality of insulators (46) which are fitted to the outer geometry (30) and are designed for the support structure to be able to be fastened to a surrounding structure or to a further support structure,
wherein the support structure arrangement (60) further comprises:
a coolant pipe (70a, 70b), which is composed of insulating material, for providing cooling liquid for power electronics modules (50) in the support structures (10a, 10b, 10c, 10d); and
at least one electrode (74b, 74c), which is arranged in the coolant pipe (70a, 70b), within the outer geometry (30) of a support structure (10a, 10b, 10c, 10d) which is connected to the support structure and/or can be electrically conductively connected to a power electronics module in the support structure in such a way that the electrode is at the potential of the support structure and/or of the power electronics module,
wherein the coolant pipe (70a, 70b) is guided along the row (62) within the outer geometries (30) of the support structures (10a, 10b, 10c, 10d), and
wherein the electrode (74b) is arranged in a first support structure (10a) in the row (62), and a further electrode (74c) is arranged in the last support structure (10d) of the row.

2. Support structure arrangement (60) according to Claim 1,
wherein the outer geometry (30) of the plurality of support structures (10) is cuboidal.

3. Support structure arrangement (60) according to Claim 1 or 2, wherein the plurality of support structures (10) each further comprises:
at least one side panel (18) which provides a flat outer surface of the outer geometry (30).

4. Support structure arrangement (60) according to Claim 3,
wherein the at least one side panel (18) is provided between pipes (16, 20, 22) of a support frame (14) of the plurality of support structures.

5. Support structure arrangement (60) according to one of the preceding claims,
wherein at least two power electronics modules (50) can be inserted into the holder (38) one behind the other.

6. Support structure arrangement (60) according to one of the preceding claims, further comprising:
at least two sliding rails (42) which are arranged in the holder (38) and on which at least one power electronics module (50) can be inserted into the holder.

7. Support structure arrangement (60) according to one of the preceding claims,
wherein the coolant pipe (70a, 70b) is guided beneath rails (42) in the support structures (10a, 10b, 10c, 10d).

8. Support structure arrangement (60) according to one of the preceding claims, further comprising:
a connecting pipe (68a, 68b), which is composed of an insulating material, for connecting the coolant pipe (70a, 70b) to a main system pipe (66a, 66b);
an electrode (74a) which is arranged in the connecting pipe and can be electrically connected to an earth potential of the modular converter.

9. Support structure arrangement according to one of the preceding claims, further comprising:
a first group (64a) of support structures in the row, and a second group (64b) of support structures in the row adjoining the first group (64a);
a further coolant pipe (86a, 86b) for the second group (64b) of support structures, which further coolant pipe is guided through the support structures of the first group (64a).

## Revendications

1. Agencement de structures porteuses (60) pour un variateur modulaire, l'agencement de structures porteuses (60) comprenant :
une pluralité de structures porteuses (10) disposées en une rangée (62), chaque structure porteuse comprenant :
un logement (38) pour insérer au moins un module d'électronique de puissance (50) ; et
un cadre porteur (14) composé de plusieurs tubes reliés ensemble (16, 22) qui forment les angles (24) et les bords (26) d'une géométrie extérieure (30) électroconductrice entourant le logement (38),
dans lequel les angles (24) et les bords (26) présentent un rayon d'arrondi supérieur à un rayon minimal prédéfini et la géométrie extérieure (30) est réalisée pour homogénéiser une intensité de champ électrique sur une face extérieure de la structure porteuse (10), et
dans lequel le cadre porteur (14) comprend deux viroles de tube (20) à coins arrondis, disposées en parallèle l'une à l'autre et reliées au moyen de tubes (22) s'étendant de manière orthogonale par rapport aux viroles de tube,
dans lequel chacune des structures porteuses (10) comprend en outre :
une pluralité d'isolateurs (46) qui sont attachés à la géométrie extérieure (30) et réalisés pour que la structure porteuse puisse être fixée à une structure environnante ou à une autre structure porteuse,
l'agencement de structures porteuses (60) comprenant en outre :
un tube de produit réfrigérant (70a, 70b) en matériau isolant pour fournir un liquide de refroidissement pour un module d'électronique de puissance (50) dans les structures porteuses (10a, 10b, 10c, 10d) ; et
au moins une électrode (74b, 74c) disposée dans le tube de produit réfrigérant (70a, 70b) à l'intérieur de la géométrie extérieure (30) d'une structure porteuse (10a, 10b, 10c, 10d) qui est reliée à la structure porteuse et/ou peut être reliée de manière électroconductrice à un module d'électronique de puissance de telle sorte que l'électrode présente le potentiel de la structure porteuse et/ou du module d'électronique de puissance,
dans lequel le tube de produit réfrigérant (70a, 70b) est guidé le long de la rangée (62) à l'intérieur des géométries extérieures (30) des structures porteuses (10a, 10b, 10c, 10d), et
dans lequel l'électrode (74b) est disposée dans une première structure porteuse (10a) de la rangée (62) et une autre électrode (74c) est disposée dans la dernière structure porteuse (10d) de la rangée.

2. Agencement de structures porteuses (60) selon la revendication 1,
dans lequel la géométrie extérieure (30) de la pluralité de structures porteuses (10) est parallélépipédique.

3. Agencement de structures porteuses (60) selon la revendication 1 ou 2, dans lequel la pluralité de structures porteuses (10) comprend en outre respectivement :
au moins un panneau latéral (18) fournissant une surface extérieure plane de la géométrie extérieure (30) .

4. Agencement de structures porteuses (60) selon la revendication 3,
dans lequel ledit au moins un panneau latéral (18) est prévu entre les tubes (16, 20, 22) d'un cadre porteur (14) de la pluralité de structures porteuses.

5. Agencement de structures porteuses (60) selon l'une quelconque des revendications précédentes,
dans lequel au moins deux modules d'électronique de puissance (50) peuvent être insérés l'un après l'autre dans le logement (38).

6. Agencement de structures porteuses (60) selon l'une quelconque des revendications précédentes, comprenant en outre :
au moins deux glissières (42) disposées dans le logement (38) et sur lesquelles au moins un module d'électronique de puissance (50) peut être inséré dans le logement.

7. Agencement de structures porteuses (60) selon l'une quelconque des revendications précédentes,
dans lequel le tube de produit réfrigérant (70a, 70b) est guidé au-dessous de glissières (42) dans les structures porteuses (10a, 10b, 10c, 10d).

8. Agencement de structures porteuses (60) selon l'une quelconque des revendications précédentes, comprenant en outre :
un tube de raccordement (68a, 68b) en matériau isolant pour raccorder le tube de produit refroidissant (70a, 70b) à un tube de système principal (66a, 66b) ;
une électrode (74a) qui est disposée dans le tube de raccordement et peut être reliée électriquement à un potentiel de masse du variateur modulaire.

9. Agencement de structures porteuses selon l'une quelconque des revendications précédentes, comprenant en outre :
un premier groupe (64a) de structures porteuses dans la rangée et un deuxième groupe (64b) de structures porteuses dans la rangée suite au premier groupe (64a) ;
un autre tube de produit réfrigérant (86a, 86b) pour le deuxième groupe (64b) de structures porteuses qui est guidé à travers les structures porteuses du premier groupe (64a).
